# DEMANDE DE BREVET EUROPEEN

(11) **EP 2 226 596 A1**
(43) Date de publication de la demande: **08.09.2010**
(21) Numéro de dépôt: 10155682.7
(22) Date de dépôt: 05.03.2010
(51) Int. Cl.: F25B 9/14, F25D 19/00, G01J 5/06, H01L 31/024

(54) **Capteur infra-rouge refroidi par refroidisseur de stirling**

(30) Priorité: 06.03.2009 FR 0951437
(71) Demandeur: SAGEM DEFENSE SECURITE, 75015 Paris (FR)
(72) Inventeur: Sik, Hervé, 95612 Cergy Pontoise Cedex (FR); Rassinoux, Philippe, 95612 Cergy Pontoise Cedex (FR)
(74) Mandataire: Callon de Lamarck, Jean-Robert

(57) **Abrégé**

L'invention concerne un capteur infra-rouge comprenant : un ensemble (100) de détecteurs quantiques infra-rouges, destiné à détecter un rayonnement (1) infra-rouge ; un refroidisseur (300) de Stirling dont une surface (11) de refroidissement peut être soumise à des vibrations sous l'effet de cycles de Stirling; un coupleur (200) disposé entre l'ensemble et le refroidisseur, pour coupler thermiquement l'ensemble (100) et le refroidisseur (300) ; **caractérisé en ce que** le coupleur (200) comprend un évidement (14) pratiqué du côté de l'ensemble (100) et s'étendant au moins en face de la surface (11) de refroidissement du refroidisseur (300) de sorte que le coupleur (200) ne soit pas en contact avec l'ensemble (100) en face de la surface (11) de refroidissement du refroidisseur (300) et que les vibrations auxquelles peut être soumise la surface du refroidisseur (300) ne soient pas transmises à l'ensemble (100), l'évidement (14) étant en outre pratiqué sur une partie de l'épaisseur du coupleur (200) sans déboucher du côté de l'ensemble refroidisseur (300).

## Description

### DOMAINE TECHNIQUE GENERAL

L'invention concerne le domaine des composants semiconducteurs et plus particulièrement celui des capteurs infra-rouges comprenant un ensemble de détecteurs quantiques d'un tel rayonnement et notamment ceux utilisés dans des dispositifs d'observation tels que des jumelles ou caméra infra-rouges.

### ETAT DE LA TECHNIQUE

Dans le domaine de l'imagerie Infra-Rouge (IR) les capteurs IR sont de plus en plus utilisés.

Dans de tels dispositifs, un réseau de détecteurs quantiques IR est disposé dans un plan focal.

Ces dispositifs sont plus connus sous le nom de détecteurs de réseau plan focal (en anglais, « *Focal Plane Arrays* », (FPA)), ci-après ensemble de détecteurs quantiques IR.

Un ensemble de détecteurs quantiques IR fonctionne de manière générale à basse température afin de réduire le courant d'obscurité des détecteurs et améliorer leur sensibilité au rayonnement IR ; il convient donc de les refroidir.

Ainsi, l'ensemble de détecteurs quantiques IR est refroidi jusqu'à une température cryogénique afin de maintenir un rapport-signal-à-bruit optimal.

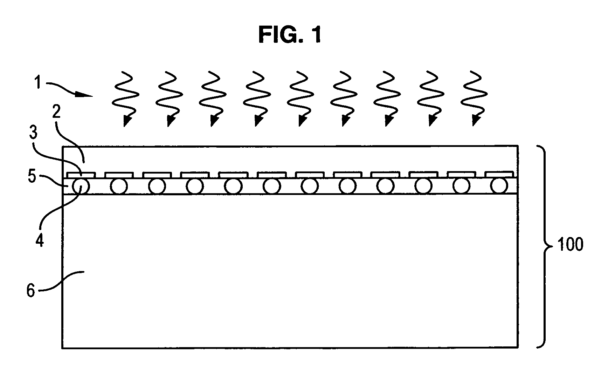

On a illustré sur la figure 1 un ensemble 100 de détecteurs quantiques IR de type connu.

Un tel ensemble 100 comprend un circuit 6 de Silicium sur lequel une couche 2 de matériau photosensible en HgCdTe ou InSb est hybridée via des plots 4 électriques, généralement en Indium.

Une colle 5 assure la protection et le maintien mécanique de l'ensemble notamment au cours des étapes d'amincissement du matériau photosensible.

En effet, pour obtenir l'ensemble 100 de détecteurs quantiques IR, le matériau photosensible 2 doit être aminci à quelques micromètres pour que le signal IR 1 photogénère des porteurs proches des zones de collection 3.

Dans ce type d'ensemble 100 de détecteurs quantiques IR, les mécanismes de génération de porteurs dans les matériaux photosensibles les composants étant thermiquement dépendants, ils sont à l'origine du bruit temporel et du courant d'obscurité.

Ainsi - comme déjà mentionné - l'ensemble 100 de détecteurs quantiques IR est mis à une température cryogénique, celle de la température de l'azote liquide (c'est-à-dire environ 77 Kelvin), afin de réduire le bruit temporel et le courant d'obscurité et obtenir de bonnes performances.

Pour refroidir l'ensemble de détecteurs quantiques IR on utilise un refroidisseur connu sous le nom de micro-refroidisseur ou machine à froid.

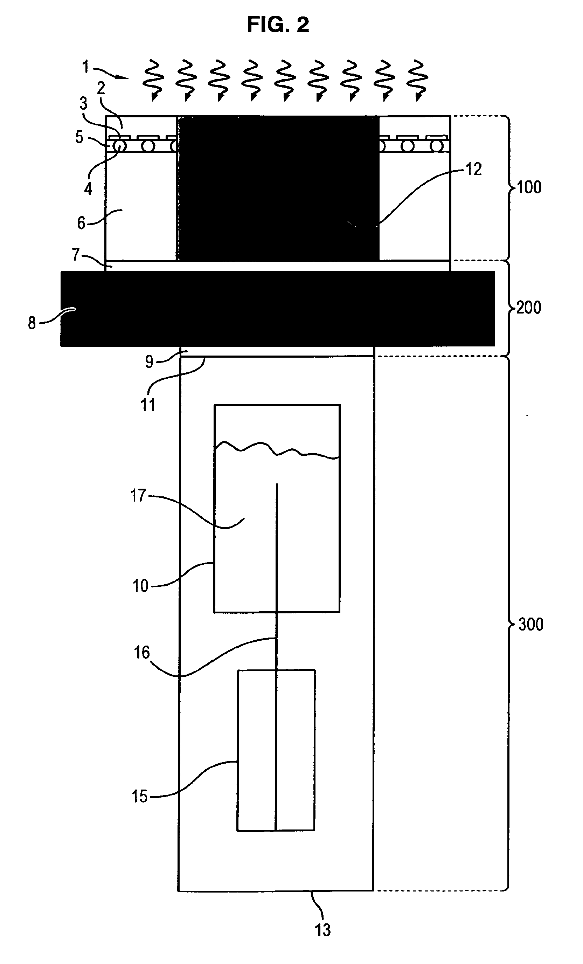

La figure 2 illustre un capteur IR de type connu comprenant un ensemble 100 de détecteurs quantiques et un refroidisseur 300.

Le capteur comprend en outre un coupleur 200 disposé entre l'ensemble 100 de détecteurs quantiques et le refroidisseur 300.

Le coupleur 200 comprend un substrat 8 de préférence en matériau isolant et bon dissipateur thermique.

Le coupleur 200 permet de coupler thermiquement le refroidisseur 300 et l'ensemble 100 de détecteurs quantiques.

Un tel couplage assure un refroidissement de l'ensemble 100 de détecteurs quantiques IR.

Un problème est que le refroidisseur 300 est un refroidisseur de Stirling dont une surface 11 de refroidissement peut être soumise à des vibrations sous l'effet de cycles de Stirling.

Ces vibrations associées au fait que les matériaux constituant l'ensemble 100 de détecteurs quantiques présentent des propriétés piézoélectriques toute variation de contrainte appliquée sur le matériau photosensible peut générer une modulation du potentiel vu par les détecteurs quantiques, une modulation du courant d'obscurité liée à une variation du taux de génération avec pour conséquence l'augmentation du bruit des détecteurs quantiques de la zone sous contrainte.

### PRESENTATION DE L'INVENTION

L'invention permet d'améliorer les performances d'un capteur infra-rouges comprenant un ensemble de détecteurs quantiques infra-rouges refroidi par un refroidisseur de Stirling.

L'invention permet en particulier de supprimer les déformations des matériaux constituant l'ensemble de détecteurs quantiques issues des cycles de pression/détente du refroidisseur de Stirling.

Ainsi, selon un premier aspect, l'invention concerne un capteur infra-rouge comprenant : un ensemble de détecteurs quantiques infra-rouges, destiné à détecter un rayonnement infra-rouge ; un refroidisseur de Stirling dont une surface de refroidissement peut être soumise à des vibrations sous l'effet de cycles de Stirling ; un coupleur disposé entre l'ensemble et le refroidisseur, pour coupler thermiquement l'ensemble et le refroidisseur.

Le capteur est **caractérisé en ce que** le coupleur comprend un évidement pratiqué du côté de l'ensemble et s'étendant au moins en face de la surface de refroidissement du refroidisseur de sorte que le coupleur ne soit pas en contact avec l'ensemble en face de la surface de refroidissement du refroidisseur et que les vibrations auxquelles peut être soumise la surface du refroidisseur ne soient pas transmises à l'ensemble, l'évidement étant en outre pratiqué sur une partie de l'épaisseur du coupleur sans déboucher du côté de l'ensemble refroidisseur.

L'évidement entre le refroidisseur et l'ensemble de détecteurs quantiques infra-rouges permet de supprimer les effets des vibrations issues du refroidisseur tout en conservant un refroidissement suffisant des détecteurs infra-rouges. Les matériaux constituant l'ensemble de détecteurs quantiques ne sont plus déformés par les cycles pression/détente du refroidisseur de Stirling.

Les performances sont donc améliorées par rapport au capteur similaire de type connu.

Le capteur peut en outre présenter les caractéristiques suivantes :
- la somme de la surface de contact entre le détecteur et le coupleur et la surface de contact entre le coupleur et le doigt froid est inférieure ou égale à la surface de contact du détecteur avec le coupleur sans évidement ;
- le refroidisseur comprend une direction longitudinale et dans lequel l'évidement est pratiqué selon au moins une direction orthogonale à la direction longitudinale du refroidisseur ;
- l'évidement est pratiqué selon une rainure comprenant un fond de dimensions supérieures ou égales à la surface de refroidissement du refroidisseur ;
- le coupleur est connecté à l'ensemble de détecteurs quantiques infra-rouges selon une pluralité d'éléments de couplage ;
- le coupleur comprend un substrat, de préférence en matériau isolant, connecté d'une part avec l'ensemble de détecteurs quantiques infra-rouges et d'autre part avec le refroidisseur, la connexion étant effectuée par des moyens de collage ;
- les éléments de couplage comprennent au moins une saignée pratiquée dans chaque élément de couplage, à proximité de l'évidement, de manière à ce que les moyens de collages ne tombent pas dans l'évidement ;
- l'ensemble de détecteurs quantiques infra-rouges comprend une couche en matériau photosensible, de préférence HgCdTe ou InSb ayant des propriétés piézoélectriques ;
- le coupleur est en matériau, de préférence en Nitrure d'Aluminium ou tout autre alliage ou céramique répondant aux contraintes suivantes : découplage des masses électriques et mécaniques, minimisation de l'effet bilame et bon conducteur thermique ;

Et selon un second aspect, l'invention concerne un dispositif d'observation infra-rouge comprenant un dispositif détecteur d'un rayonnement infra-rouge selon le premier aspect de l'invention.

### PRESENTATION DES FIGURES

D'autres caractéristiques et avantages de l'invention ressortiront encore de la description qui suit laquelle est purement illustrative et non limitative et doit être lue en regard des dessins annexés sur lesquels outre les figures 1 et 2 déjà discutées :
- la figure 3 illustre un dispositif détecteur d'un rayonnement infra-rouge selon l'invention ;
- la figure 4 illustre un substrat utilisé dans le dispositif détecteur d'un rayonnement infra-rouge selon l'invention ;
- les figures 5a à 5b illustrent plusieurs configurations d'un évidement du substrat plan utilisé dans le dispositif détecteur d'un rayonnement infra-rouge selon l'invention ;
- les figures 6a et 6b illustrent respectivement les performances d'un capteur infra-rouge de type connu et d'un capteur infra-rouge selon l'invention ;
- la figure 7 illustre une vue de dessus du substrat avec des pièges à colle pratiqués sur chaque élément de couplage ;
- la figure 8 illustre de manière schématique les éléments constitutifs du détecteur selon l'invention.

### DESCRIPTION DETAILLEE DE L'INVENTION

### Structure du capteur

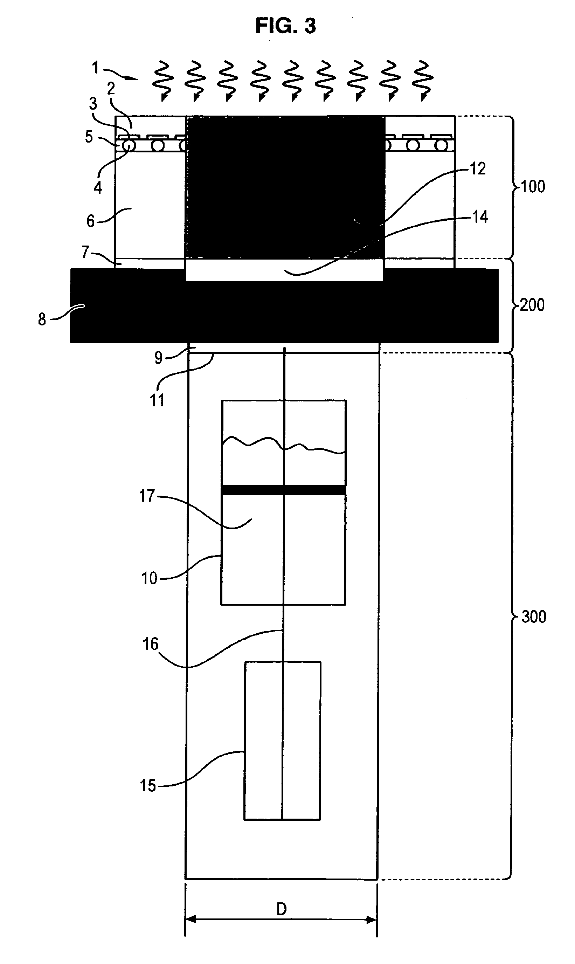

La figure 3 illustre un capteur IR comprenant un ensemble 100 de détecteurs quantiques IR destiné à détecter un rayonnement 1 IR, un refroidisseur 300 de Stirling dont une surface 11 de refroidissement peut être soumise à des vibrations sous l'effet de cycles de Stirling et un coupleur 200 disposé entre l'ensemble 100 de détecteurs quantiques IR et le refroidisseur 300.

Afin d'éviter que le refroidisseur 300 ne cause des perturbations du fait des vibrations engendrées par les cycles de Stirling, le coupleur 200 comprend un évidement 14 pratiqué du côté de l'ensemble 100 de détecteurs quantiques IR.

L'évidement 14 s'étend au moins en face de la surface 11 de refroidissement du refroidisseur 300 de sorte que le coupleur 200 ne soit pas en contact avec l'ensemble 100 de détecteurs quantiques IR et que les vibrations auxquelles peut être soumis la surface 11 du refroidisseur 300 ne soient pas transmises à l'ensemble 100 de détecteurs quantiques IR.

La profondeur de l'évidement est de l'ordre de 50 à 100 micromètres.

De manière plus précise, le coupleur 200 comprend un substrat 8 dans lequel est pratiqué l'évidement 14. Le substrat 8 est de préférence parallélépipédique.

L'évidement 14 n'est pas pratiqué sur toute l'épaisseur du coupleur 200. En d'autres termes, il ne débouche pas du côté du refroidisseur 300.

L'évidement 14 absorbe donc les vibrations tout en assurant un refroidissement suffisant de l'ensemble 100 de détecteurs quantiques IR bien que la surface 81 du substrat couplé à l'ensemble 100 de détecteurs quantiques IR soit moins important que dans les capteurs de type connu (voir figure 2). Les matériaux qui constituent l'ensemble 100 de détecteurs quantiques IR ne sont plus déformés.

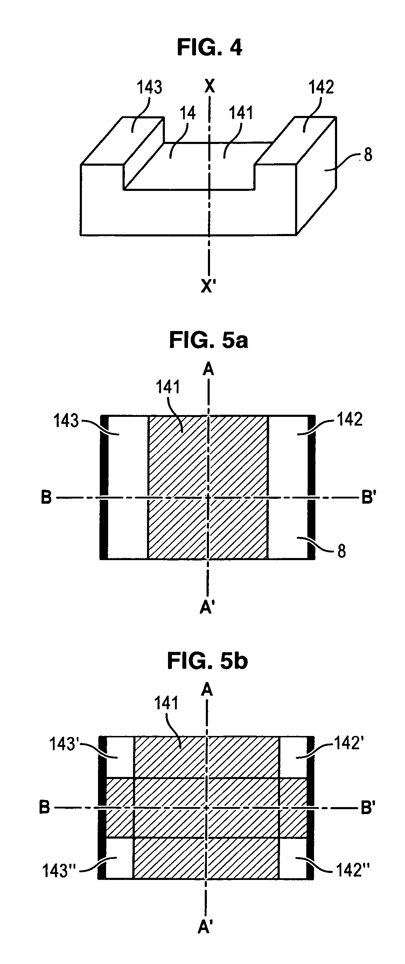

La figure 4 illustre le substrat 8 avec un évidement 14 en forme de rainure pratiquée selon une direction AA' orthogonale à une direction LL' longitudinale du refroidisseur 300.

La figure 5a est une vue de dessus du substrat 8 illustré sur la figure 4. Les figures 5b et 5c illustrent une vue de dessus du substrat 8 avec un évidement 14 selon deux autres modes de réalisation.

Sur la figure 5b l'évidement 14 est en forme de rainure pratiquée selon deux directions orthogonales à la direction LL' longitudinale du refroidisseur 300. Dans ce mode de réalisation, la rainure a une forme de croix.

Sur chacun des modes de réalisation, la rainure pratiquée comprend un fond de dimensions supérieures ou égales à la surface 11 de refroidissement du refroidisseur 300.

En d'autres termes, pour que les vibrations du refroidisseur 300 ne soient pas transmises à l'ensemble 100 de détecteurs quantiques IR, l'évidement doit être fonction de la surface 11 de refroidissement du refroidisseur 300.

Le substrat 8 est connecté à l'ensemble 100 de détecteurs quantiques selon au moins deux éléments de couplage.

Sur la figure 5a on a deux 142', 142" éléments de couplage et sur la figure 5b on a quatre 142', 142", 143', 143" éléments de couplage.

La connexion avec, d'une part, l'ensemble 100 de détecteurs quantiques et, d'autre part, avec le refroidisseur 300 est effectuée via de la colle déposée en couche 7, 9 avec les surfaces connectées.

L'évidement 14 étant de faible profondeur au cours du collage de l'ensemble 100 de détecteurs quantiques il se peut que de la colle ne déborde et ne tombe dans l'évidement 14. L'évidement 14 étant de faible profondeur, la colle peut le boucher tout ou partie.

Pour éviter que de la colle 7, 9 ne bouche l'évidement 14 on peut prévoir des pièges à colle sur chaque élément de couplage.

Les pièges à colle piègent la colle au cours du collage.

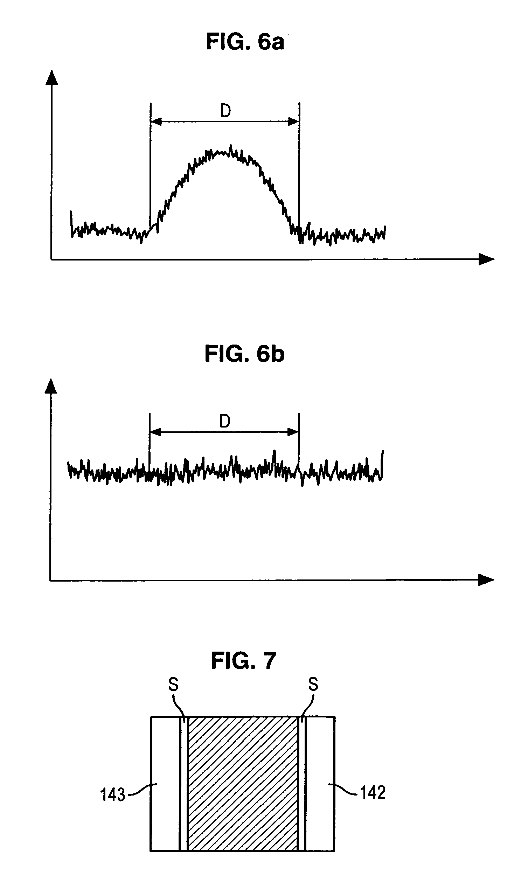

On a illustré sur la figure 7 une vue de dessus du substrat avec des pièges à colle sur les éléments de couplage 142, 143. Les pièges à colle sont des saignées S pratiquées dans chaque élément de couplage 142, 143 à proximité de l'évidement 14.

Pour éviter que l'évidement ne soit bouché, on peut aussi augmenter la profondeur de l'évidement 14.

Le refroidisseur 300 - comme déjà mentionné - est un refroidisseur 300 de Stirling et comprend des moyens 15, 16 pour générer une onde de pression dans un fluide ou gaz 17 et la transmettre à la surface 11 de refroidissement du refroidisseur 300.

Les moyens pour générer l'onde de pression dans le fluide sont de préférence composés d'un moteur 15 connectés à un piston. Le fluide ou gaz 17 est quant à lui contenu dans une enceinte située à l'intérieur du refroidisseur 300.

Le capteur IR tel que décrit peut être implémenté dans un dispositif d'observation IR tel que des jumelles IR ou une caméra IR.

### Optimisation du Capteur

Comme mentionné ci-dessus, il convient d'optimiser la structure du capteur pour maintenir voire augmenter l'efficacité de refroidissement du système (consommation, durée de mise en froid) tout en assurant un découplage mécanique entre le doigt froid et le détecteur.

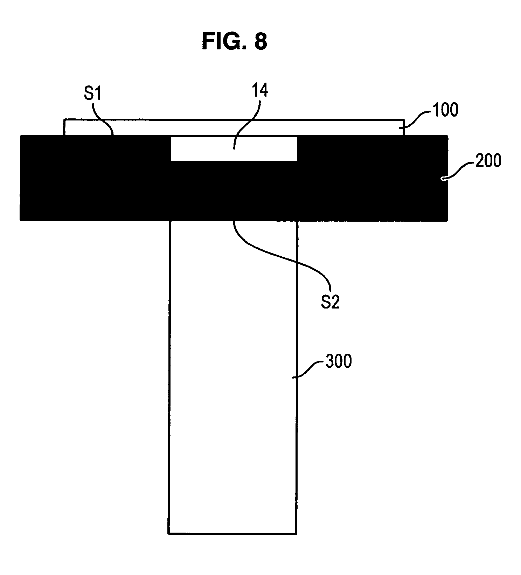

La figure 8 illustre de manière schématique l'agencement des éléments constitutifs du capteur, sur cette figure ne sont pas représentés les couches de colle 7, 9 comme sur la figure 3.

Pour obtenir une augmentation de l'efficacité de refroidissement tout en assurant un découplage mécanique entre le refroidisseur 300 et l'ensemble de détection 100, il convient de s'assurer que la somme de la surface S1 de contact entre l'ensemble de détection 100 et le coupleur 200 et la surface S2 de contact entre le coupleur 200 et le refroidisseur 300 soit inférieure ou égale à la surface de contact de l'ensemble de détection 100 avec le coupleur 200 sans évidement 14.

De cette manière, on maximise le contact du coupleur 200 avec le détecteur et le refroidisseur 300.

En tout état de cause, l'évidement 14 doit être minimisée mais la surface de l'évidement 14 du côté de l'ensemble de détection 100 doit être supérieure ou égale à la surface de l'ensemble refroidisseur 300 pour permettre une surface de contact optimale du côté de l'ensemble de détection 100.

Du côté du refroidisseur 300 le contact devra quant à lui être total.

Le coupleur 200 est de préférence dans un matériau choisi de manière à dissiper la température le plus efficacement possible, en conservant par ailleurs des propriétés mécanique et électriques compatibles de l'application (découplage des masses mécanique et électrique, minimisation de l'effet bilame).

Parmi les matériaux envisageables l'AIN (nitrure d'aluminium) sous toutes ses formes cristallines et céramiques, présente un bon compromis, sans que ce soit l'unique solution.

On peut en effet envisager tout autre matériau III/V de la table de Mendeleiev, voire d'autres alliages ou céramiques qui satisfasse les contraintes précitées.

La solution présentée permet d'obtenir un maintien des performances cryogéniques du système sans perte de dynamique de refroidissement et la disparition des effets vibratoires néfastes.

Par ailleurs, cette approche permet de réduire la masse thermique du système en n'ajoutant aucun élément supplémentaire pour assurer le découplage mécanique.

Enfin, pour assurer une efficacité totale, il est indispensable que l'élément de collage utilisé pour coupler le détecteur au coupleur ne s'infiltre pas dans l'évidement. Des pièges à colle sont réalisés à cette fin (voir ci-dessus).

### Performances

On a illustré sur les figures 6a et 6b le bruit mesuré au niveau de la zone D où le substrat 8 est en contact avec l'ensemble 100 de détecteurs quantiques IR. Cette zone correspond à l'endroit où est appliqué le refroidisseur 300.

La figure 6a correspond à la configuration de la figure 2, c'est-à-dire sans évidement pratiqué dans le substrat 8 tandis que la figure 6b correspond à la configuration de la figure 3, c'est-à-dire avec un évidement 14 pratiqué dans le substrat 8.

On obtient bien une suppression du bruit au niveau de la zone D où le refroidisseur est appliqué sur le substrat 8.

Le bruit est constant sur toute la largeur du substrat 8, il n'y a plus de bruit additionnel issu des vibrations du refroidisseur, les performances sont donc améliorées.

## Revendications

1. Capteur infra-rouge comprenant
- un ensemble (100) de détecteurs quantiques infra-rouges, destiné à détecter un rayonnement (1) infra-rouge ;
- un refroidisseur (300) de Stirling dont une surface (11) de refroidissement peut être soumise à des vibrations sous l'effet de cycles de Stirling;
- un coupleur (200) disposé entre l'ensemble et le refroidisseur, pour coupler thermiquement l'ensemble (100) et le refroidisseur (300) ;
**caractérisé en ce que** le coupleur (200) comprend un évidement (14) pratiqué du côté de l'ensemble (100) et s'étendant au moins en face de la surface (11) de refroidissement du refroidisseur (300) de sorte que le coupleur (200) ne soit pas en contact avec l'ensemble (100) en face de la surface (11) de refroidissement du refroidisseur (300) et que les vibrations auxquelles peut être soumise la surface du refroidisseur (300) ne soient pas transmises à l'ensemble (100), l'évidement (14) étant en outre pratiqué sur une partie de l'épaisseur du coupleur (200) sans déboucher du côté de l'ensemble refroidisseur (300).

2. Capteur selon la revendication 1 dans lequel la somme de la surface (S1) de contact entre le détecteur (100) et le coupleur (200) et la surface (S2) de contact entre le coupleur (200) et le doigt froid (300) est inférieure ou égale à la surface de contact du détecteur (100) avec le coupleur (200) sans évidement (14).

3. Capteur selon l'une des revendications 1 à 2 dans lequel le refroidisseur comprend une direction (LL') longitudinale et dans lequel l'évidement (14) est pratiqué selon au moins une direction (AA') orthogonale à la direction (LL') longitudinale du refroidisseur.

4. Capteur selon l'une des revendications 1 à 3 dans lequel l'évidement (14) est pratiqué selon une rainure comprenant un fond (141) de dimensions supérieures ou égales à la surface (11) de refroidissement du refroidisseur (300).

5. Capteur selon l'une des revendications 1 à 4 dans lequel le coupleur (200) est connecté à l'ensemble de détecteurs quantiques infra-rouges selon une pluralité d'éléments (142, 143) de couplage.

6. Capteur selon l'une des revendications 1 à 5 dans lequel le coupleur (200) comprend un substrat (8), de préférence en matériau isolant, connecté d'une part avec l'ensemble (100) de détecteurs quantiques infra-rouges et d'autre part avec le refroidisseur (300), la connexion étant effectuée par des moyens (7, 9) de collage.

7. Capteur selon la revendication 6, dans lequel les éléments de couplage comprennent au moins une saignée (S) pratiquée dans chaque élément de couplage, à proximité de l'évidement, de manière à ce que les moyens de collages ne tombent pas dans l'évidement (14).

8. Capteur selon l'une des revendications 1 à 7 dans lequel l'ensemble (100) de détecteurs quantiques infra-rouges comprend une couche (2) en matériau photosensible, de préférence HgCdTe ou InSb ayant des propriétés piézoélectriques.

9. Capteur selon l'une des revendications 1 à 8 dans lequel le coupleur (200) est en matériau, de préférence en Nitrure d'Aluminium ou tout autre alliage ou céramique répondant aux contraintes suivantes : découplage des masses électriques et mécaniques, minimisation de l'effet bilame et bon conducteur thermique.

10. Dispositif d'observation infra-rouge comprenant un dispositif détecteur d'un rayonnement infra-rouge selon l'une des revendications 1 à 9.
